# EUROPÄISCHE PATENTSCHRIFT

(11) **EP 1 336 201 B1**
(45) Veröffentlichungstag und Bekanntmachung des Hinweises auf die Patenterteilung: **11.02.2015**
(21) Anmeldenummer: 01997847.7
(22) Anmeldetag: 08.11.2001
(51) Int. Cl.: G06K 19/073, H01L 23/522, H01L 23/58, H01L 27/02

(54) **INTEGRIERTE SCHALTUNGSANORDNUNG MIT ANALYSIERSCHUTZ**
INTEGRATED CIRCUIT CONFIGURATION THAT IS PROTECTED AGAINST ANALYSIS
SYSTEME DE CIRCUIT INTEGRE PROTEGE DE L'ANALYSE

(30) Priorität: 23.11.2000 DE 10058078
(43) Veröffentlichungstag der Anmeldung: 20.08.2003
(73) Patentinhaber: Infineon Technologies AG, 85579 Neubiberg (DE)
(72) Erfinder: JANKE, Marcus, 81539 München (DE)
(74) Vertreter: Viering, Jentschura & Partner Patent- und Rechtsanwälte
(86) Internationale Anmeldenummer: PCT/DE2001/004198
(87) Internationale Veröffentlichungsnummer: WO 2002/043147

(56) Entgegenhaltungen:
- EP-A- 0 378 306
- EP-A- 0 764 985
- EP-A- 0 948 052
- WO-A-00/28399
- WO-A-99/16131
- WO-A1-00/11719
- WO-A2-00/19490
- US-A- 4 434 361
- US-A- 5 345 105
- US-A- 5 861 652
- US-A- 5 883 000
- US-A- 5 998 858
- US-A- 6 014 052
- US-A- 6 137 318
- PATENT ABSTRACTS OF JAPAN vol. 1999, no. 01, 29. Januar 1999 (1999-01-29) -& JP 10 270562 A (NIPPON TELEGR &TELEPH CORP <NTT>), 9. Oktober 1998 (1998-10-09)

## Beschreibung

Die vorliegende Erfindung betrifft eine integrierte Schaltungsanordnung mit einem Substrat, das Schaltungselemente aufweist, und einer Verdrahtungsebene mit ersten Leitungsbahnen.

Bei integrierten Schaltungen, besonders bei deren Einsatz in Chipkarten, ist es für einen potentiellen Angreifer möglich, eine Analyse der integrierten Schaltung, dem sogenannten "Reverse Engineering", durchzuführen, und mit den erhaltenen Informationen entweder die Funktionsweise der Schaltung zu verändern oder eine Datenmanipulation in deren Speicher durchzuführen. Dieses Verfahren kann besonders bei sicherheitsrelevanten Schaltungen, etwa mit Geldkarten- oder Zutrittsberechtigungsfunktionen, zu unerwünschten Folgen führen. Typischerweise wird bei dieser Analyse das den Chip bedeckende Material sowie ein Teil der die Verdrahtung des Chips schützenden obere Schichten entfernt. Bei den dann freiliegenden oberen Leiterbahnen handelt es sich meistens um nicht sicherheitsrelevante Leitungen, welche durch sogenannte Bypass-Leitungen umgeleitet werden können, um weiter zu tieferen Schichten und Leitungen zu gelangen. Mit einigem Aufwand können diese Schritte heute mit der "FIB-Methode" ("Focussed-Ion-Beam") durchgeführt werden. Sobald tieferliegende, sicherheitsrelevante und damit kritische Leitungen erreicht sind, können an diesen entweder Signale und Pulse abgegriffen werden (sog. "Probing"), oder es können diese Leitungen mit Signalen beaufschlagt werden, um Daten zu manipulieren (sog. "Forcing").

Es war daher in der Vergangenheit das Ziel, die Analyse und Manipulation der integrierten Schaltungen zu verhindern oder wenigstens zu erschweren, welches einerseits durch eine versteckte Strukturierung der kritischen Leitungen im Verdrahtungsplan zu lösen versucht wurde, und welches andererseits durch Aufbringen einer dedizierten, abdeckenden Schutzebene über den relevanten Verdrahtungsebenen angegangen wurde. Bei diesen Schutzebenen, englisch: "Shields", werden bekanntermaßen mäander- oder gitterförmige Leitungen z.B. in Paaren in der Schutzebene realisiert, bei deren Unterbrechung oder Kurzschluss für den Fall, dass verschiedene Spannungen anliegen, der detektierende Sensor ein Löschen des Speichers, einen Reset oder die Funktionsuntüchtigkeit anderer Schaltungsteile veranlasst. Eine Ausführung dieser "passiv" genannten Leitungen als unangeschlossene, spannungslose Leitungen ist ebenfalls möglich. Sie dienen in diesem Fall lediglich noch zu einer Erhöhung des Aufwandes beim Angriff bzw. zur Verwirrung.

Die Sicherheit der Bausteine lässt sich noch erhöhen, indem die beschriebenen passiven Leitungen durch sogenannte aktive Leitungen beim Design des Verdrahtungsplanes ersetzt werden. Bei diesen werden die Leitungen des Shields durch Ansteuerschaltungen mit Signalen beaufschlagt, welche von Auswerteschaltungen analysiert und z.B. mit Referenzsignalen verglichen werden. Wegen der möglichen Variation der Signale kann dabei das Shield nur durch das sehr aufwendige Verlegen einer Bypassleitung durch die FIB-Methode umgangen werden.

Während integrierte Schaltungen konventioneller Logikbausteine mit im wesentlichen manuell gesteuerten Design (Full Custom-Design) erstellt werden, ist die manuelle Bearbeitung bzw. Beeinflussung bei der sich heute immer stärker durchsetzenden synthetisierten Logik nur mit höherem Aufwand möglich. Bei diesem Verfahren werden Funktionen und Beziehungen von Objekten in einer höheren Programmiersprache, z.B. VHDL, formuliert und durch ein Kompilierungsprogramm in einen fertigen Verdrahtungsplan übersetzt. Da sich die Schutzeigenschaften der Shield-Leitungen aus von der eigentlichen Schaltung unabhängigen Funktionen sowie ihrer räumlichen Lage ergeben, diese aber beim Syntheseverfahren nicht a priori feststehen können, kann bei dieser Methode leider nur im nachherein der Verdrahtungsplan manuell mit Aufwand um Schutzebenen ergänzt werden, welches im Kontrast zu dem gewünschten Effizienz- und Zeitvorteil bei der Erstellung der integrierten Schaltung steht.

Dabei können gerade die mit einem Syntheseverfahren erstellten integrierten Schaltungen besonders angreifbar sein, denn die meiste Verdrahtung erfolgt in den tieferen Schichten, während in den oberen Schichten der Füllgrad mit Leitungen immer geringer wird. Dadurch ist es dem potentiellen Angreifer möglich, ohne auf in oberen Verdrahtungsebenen liegende Leitungen zu stoßen, z.B. vom Spitzenmeßplatz aus mit Nadeln direkt zu den tiefliegenden, sicherheitsrelevanten, kritischen Leitungen zu gelangen.

Die Druckschrift WO 00/11719 A1 beschreibt einen Halbleiterchip mit einer Schutzabdeckung in Form einer mäanderförmig verlaufenden Leitung mit zwei Anschlusspunkten, die beispielsweise in der obersten Metalllage eines konventionellen Herstellungsprozesses für Halbleiterschaltungen realisiert wird.

Die Druckschrift WO 00/28399 A1 beschreibt eine Schutzschaltung für eine integrierte Schaltung mit voneinander getrennten, parallel verlaufenden Leiterbahnen, die mäanderförmig verlaufen und einen Bereich in einer Schaltungsebene der integrierten Schaltung abdecken.

Es ist die Aufgabe der vorliegenden Erfindung, eine integrierte Schaltungsanordnung, welche einen hohen Schutz gegen von außen angreifende Analyseverfahren bei niedrigem Aufwand und geringen Kosten bietet, besonders für den Fall, dass der Verdrahtungsplan in einem Syntheseverfahren erstellt wurde.

Die Aufgabe wird erfindungsgemäß durch die Maßnahmen des Patentanspruchs 1 gelöst.

Ein Chipstapel, bei welchem durch Leiterbahnen die Analyse verhindert werden soll, ist aus der WO 00/67319 A1 bekannt.

Gemäß der vorliegenden Erfindung wird eine integrierte Schaltungsanordnung vorgeschlagen, bei welcher durch Auffüllen der von den die bestimmungsgemäße Funktion der integrierten Schaltung unterstützenden Leiterbahnen freigelassenen Bereiche mit den zum Schutz der integrierten Schaltung dienenden Leiterbahnen für jede Ebene ein maximaler Füllgrad an Leiterbahnen ermöglicht wird. Zum einen erhöht sich dadurch für den potentiellen Angreifer beim Reverse Engineering die Anzahl der zu untersuchenden Leiterbahnen je Verdrahtungsebene, zum anderen ist es für den potentiellen Angreifer nicht von vornherein feststellbar, welche Leiterbahnen in der Verdrahtungsebene zur eigentlichen integrierten Schaltung und welche nur zum Schutz dieser Schaltung dienen. Somit entsteht der Vorteil, dass die Auffüllung und die gemeinsame Positionierung der beiden Zuordnungen von Leiterbahnen in einer Verdrahtungsebene zu einem beträchtlich höheren Aufwand beim Reverse Engineering führen.

Die erfindungsgemäße integrierte Schaltungsanordnung kann Substrate mit aktiven Schaltungselementen als auch solche z.B. als sog. Flip-Chips verwendete integrierte Schaltungsanordnungen ohne aktive Schaltungselemente umfassen, wobei letztere gewöhnlich umgedreht mit der strukturierten Seite wiederum auf die Strukturseite eines aktive Schaltungselemente umfassenden Substrates geklebt werden. Diese ergeben gemeinsam wieder genau eine erfindungsgemäße Schaltungsanordnung.

Es sei ausdrücklich darauf hingewiesen, dass in diesem Dokument gemäß der vorliegenden Erfindung der Begriff Schaltungselemente auch Leiterbahnen umfasst. So kann die erfindungsgemäße integrierte Schaltungsanordnung auch Anwendung in den genannten, z.B. lediglich Leiterbahnen umfassenden Flip-Chips finden, welche dementsprechend als erweiterter Schutz für einen aktive Schaltungselemente umfassenden Chip dienen können.

Besonders vorteilhaft erweist sich die vorliegende Erfindung für in Syntheseverfahren erstellte integrierte Schaltungen. Möglicherweise nicht im Syntheseverfahren durch Leiterbahnen in oberen Verdrahtungsebenen überdeckte und damit frei- und tieferliegende kritische Leiterbahnen können durch Auffüllen der gerade über der betroffenen Leiterbahn liegenden freigelassenen Bereiche mit den zum Schutz der integrierten Schaltung dienenden Leiterbahnen nach Beendigung des Syntheseverfahrens abgedeckt werden. Eine denkbare Anwendung vor oder während des Syntheseverfahrens ist allerdings auch zu berücksichtigen. Vorzugsweise werden die Anordnungen gemäß der vorliegenden Erfindung durch ein Füllprogramm realisiert, welches sich idealerweise an das Syntheseverfahren anschließt. Neben dem Geschwindigkeitsvorteil bietet sich dadurch die Möglichkeit, dass durch Schaffung einer neuen Bausteinversion mit Veränderungen im Verdrahtungsplan der integrierten Schaltung ebenfalls ein völlig neuer Verdrahtungsplan der Schutzleitungen erstellt wird. Somit betrifft die Analyse zum Reverse Engineering nicht nur die Untersuchung kleiner Veränderungen von einer Bausteinversion zur nächsten, sondern es muss die Analyse mit hohem Aufwand völlig neu durchgeführt werden.

Da in der vorliegenden integrierten Schaltungsanordnung keine dedizierte Ebene für Schutzleiterbahnen vorzusehen ist, weil sich die entsprechenden Leiterbahnen in den bereits verdrahteten Ebenen befinden, entstehen keine zusätzlichen Kosten für den Aufbau von Metallebenen. Dieser wirtschaftliche Vorteil kann hingegen auch bei im Full-Custom-Design erstellten integrierten Schaltungen gewonnen werden, wenn die entsprechenden Schutzleiterbahnen in freigelassene Bereiche der manuell zusammengestellten Bibliotheksmodule bzw. Leiter- und Versorgungsbahnen hineingefüllt bzw. -platziert werden unter Verzicht auf die hierbei üblicherweise verwendete dedizierte Schutzebene.

Ein weiterer Aspekt stellt die mögliche Mehrlagigkeit von Bereichen mit Leiterbahnen zum Schutz der integrierten Schaltung dar. Neben der durch die Mehrschichtigkeit gegebenen Erhöhung des Aufwandes lassen sich dadurch verschiedene Schutzmechanismen kombinieren, wie etwa kapazitive Sensorleitungen in einer ersten Ebene und mit Komparatoren versehene Signal- und Sensorleitungen in einer zweiten Ebene, welche das aufeinanderfolgende Entfernen von Ebenen und Untersuchen von Leiterbahnen auf vorteilhafte Weise erheblich erschweren.

Weitere vorteilhafte Ausgestaltungen ergeben sich aus den untergeordneten Patentansprüchen.

Die Erfindung wird im folgenden anhand eines Ausführungsbeispieles näher erläutert. Dabei zeigt:

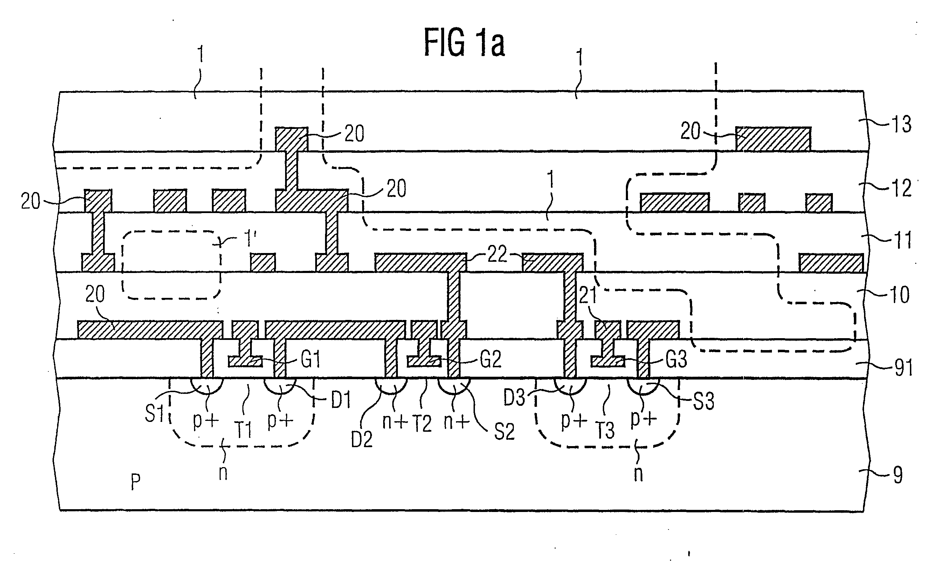

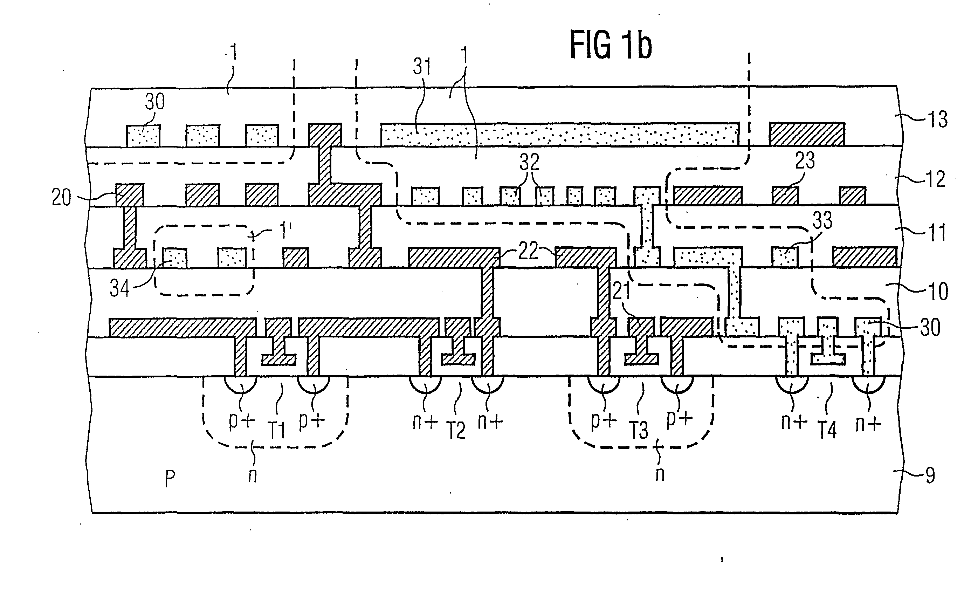

- Figur 1: zeigt einen Querschnitt durch eine beispielhafte, in einem Syntheseverfahren erstellte Schaltungsanordnung mit Transistoren und Leiterbahnen in vier Metallebenen (a) vor, d. h. nach dem Stand der Technik, und (b) nach dem Auffüllen.

In Figur la ist ein mit einem Syntheseverfahren erstellter Verdrahtungsplan einer integrierten Schaltungsanordnung nach dem Stand der Technik gezeigt. Im dargestellten Querschnitt der beispielhaften Anordnung sind auf dem Substrat 9 drei Transistoren T1, T2 und T3 dargestellt, wovon die Transistoren T1, T2 gerade einen CMOS-Inverter darstellen. In einer auf dem Substrat liegenden Isolierschicht 91 befinden sich die entsprechenden Gateelektroden G1-G3 sowie Metallkontakte zu den Sourcebereichen S1-S3 und Drainbereichen D1-D3 der drei Transistoren. Auf dieser Schicht befindet sich die erste Metallebene 10 mit aufliegender Isolationsschicht mit den der Verdrahtung der Bauelemente dienenden Leiterbahnen 20. Bedingt durch Kreuzungen der Leiterbahnen 20 müssen diese auch auf höherliegende, untereinander durch Isolationsschichten getrennte Metallebenen 11,12 und 13 ausweichen, wobei im allgemeinen besonders Versorgungsleitungen in die obersten Metallagen gelegt werden. Der die Beziehungen und Funktionsweisen der jeweiligen Bauelemente widerspiegelnde VHDL-Programmcode wird durch ein Kompilierprogramm übersetzt, wobei ein optimierter, z.B. möglichst kurze Verdrahtungswege angebender Verdrahtungsplan entsteht. Dadurch wird die unterste Metallage 10 am stärksten mit Leiterbahnen belegt, während dieser Füllgrad zu oberen Metallagen hin stärker abnimmt. Auf diese Weise entstehen im Verdrahtungsplan sich zu höheren Metallagen hin aufweitende von Leiterbahnen freigelassene Bereiche 1, 1', wobei aber auch die durch das Kompilierprogramm nicht weiter genutzten, freigelassenen Bereiche l'entstehen können, welche von Leiterbahnen umschlossen sind.

Gemäß dieser Schaltungsanordnung wäre es für einen potentiellen Angreifer zum Zwecke des Angriffs nach Abtragen der Isolationsschichten zwischen den Metallagen 10-13 möglich zu den in der ersten Metallage 10 liegenden sicherheitsrelevanten Leiterbahnen 21 des Transistors T3 oder den noch in der zweiten Metallage 11 liegenden Leiterbahnen 22 der Transistoren T2, T3 z.B. mit Nadeln zu gelangen, um hier das Probing oder Forcing durchzuführen.

Gemäß dem der erfindungsgemäßen integrierten Schaltungsanordnung zugrundeliegenden Herstellungsverfahren werden die z.B. im Syntheseverfahren von Leiterbahnen freigelassenen Bereiche 1 mit weiteren, dem Schutz der integrierten Schaltung dienenden Leiterbahnen 30 aufgefüllt. Dies kann manuell erfolgen, sollte aber idealerweise durch ein rechentechnisches Füllprogramm realisiert werden, welches die freigelassenen Bereiche detektiert und mit Leiterbahnen unter Einhaltung vorzugebender Schutzfunktionen auffüllt. Möglicherweise noch freie Bereiche auf dem Substrat können dabei für die Bauelemente der Sensorleitungen genutzt werden, wie der in Figur 1b gezeigte Transistor T4. Die als Sensorleitungen dienenden Leiterbahnen 30 füllen dabei die freigelassenen Bereiche 1 möglichst dicht auf, um allein schon durch ihre Position den Zugang durch Nadeln von einem Spitzenmessplatz aus oder durch die FIB-Methode zu den kritischen Leiterbahnen 21,22 zu behindern. Durch Beaufschlagung der Leiterbahnen 30 mit Signalen durch die z.B. Transistoren T4 beinhaltenden Auswerte- bzw. Ansteuervorrichtungen kann mittels eines Vergleiches mit einem Referenzsignal die Unversehrtheit der Leiterbahnen 30 gegenüber Kurzschluss oder Umleitung überprüft werden. Bei Ungleichheit der Signale wird durch die Auswertevorrichtung z.B. ein Reset oder ein Löschen des Speichers der integrierten Schaltung veranlasst.

Der potentielle Angriff wird besonders erschwert durch eine gitter- oder mäanderförmige Ausformung der Leiterbahnen 31, 32. Da die Ausrichtung der Leiterbahnen 31 in der Metallebene 13 senkrecht zu den in der darunterliegenden Metallebene 12 positionierten Leiterbahnen 32 gewählt ist, wird es für den potentiellen Angreifer besonders schwierig, zu den darunterliegenden Leitungen zu gelangen, da in diesem Falle durch das Ausheben des Loches, mit dem die Nadel, oder der FIB an die Leiterbahn 22 gelangen soll, sehr viele darüberliegende Leiterbahnen 31 der Metallebene 13 und Leiterbahnen 32 der Metallebene 12 unterbrochen werden müssen, welche dann vom potentiellen Angreifer jeweils einzeln zu untersuchen bzw. umzuleiten sind.

Ein weiterer Vorteil bietet sich durch die Überprüfung in oberen Metallagen liegender Leiterbahnen der integrierten Schaltung mittels darunterliegender zum Schutz dienender Leiterbahnen an. In Figur 1b ist dies durch die Leiterbahn 23 der Metallebene 12 dargestellt, unterhalb welcher die Leiterbahn 33 auf weitestgehender Länge parallel verläuft. Durch die Detektion der Unterbrechung der Leiterbahn 33 kann dabei nämlich sofort auf die gleichzeitige Unterbrechung der Leiterbahn 23 oder einen Angriff auf diese geschlossen werden, wodurch mittels der Auswertelogik eine Änderung des Betriebsmodus der integrierten Schaltung veranlasst werden kann.

Auch für den Fall, dass freigelassene Bereiche 1' nicht durch Ansteuer- bzw. Auswertevorrichtungen erreicht werden können, bietet sich die Möglichkeit, nur zur Verwirrung dienende anschlussfreie Leiterbahnen 34 vorzusehen. Desweiteren wird durch das Auffüllen mit Leiterbahnen der im allgemeinen durchgeführte Schritt des Einfügens einer Metallfläche zur Stabilisierung von Schichtoberflächen überflüssig. Somit wird bei keinem oder nur geringem Mehraufwand die Sicherheit des Bausteins vorteilhaft erhöht.

### Bezugszeichenliste

1 von ersten Leiterbahnen freigelassene Bereiche
1' umschlossene, von ersten Leiterbahnen freigelassene Bereiche
9 Substrat
10 erste Metallebene
11 zweite Metallebene
12 dritte Metallebene
13 vierte Metallebene
20 erste Leiterbahnen (Gesamtheit)
21 kritische Leiterbahnen in erster Metallebene
22 kritische Leiterbahnen in zweiter Metallebene
23 kritische Leiterbahnen in dritter Metallebene
30 dem Schutz dienende zweite Leiterbahnen (Gesamtheit)
31 mäanderförmige Leiterbahnen der vierten Metallebene
32 mäanderförmige Leiterbahnen der dritten Metallebene
33 zu 23 parallel verlaufende Leiterbahn
34 anschlussfreie Leiterbahn
T1-T4 Transistoren
G1-G3 Gateelektroden
S1-S3 Sourcebereiche
D1-D3 Drainbereiche

## Patentansprüche

1. Integrierte Schaltungsanordnung mit einem Substrat (9), das Schaltungselemente aufweist, und einer Mehrzahl von Verdrahtungsebenen (10-13) mit die bestimmungsgemäße Funktion der integrierten Schaltung unterstützenden ersten Leiterbahnen (20), wobei in den Verdrahtungsebenen zweite Leiterbahnen (30) in von den ersten Leiterbahnen (20) freigelassenen Bereichen (1) zum Schutz der integrierten Schaltungsanordnung platziert sind, wobei an den zweiten Leiterbahnen (30) eine Ansteuerungs- und eine Auswerteschaltung zur Detektion einer Unterbrechung, eines Kurzschlusses einer der zweiten Leiterbahnen (31-33) mit einer weiteren Leiterbahn, oder einer Umleitung der zweiten Leiterbahnen (31-33) angeschlossen sind, wobei zweite Leiterbahnen (31, 32) in zwei übereinander liegenden Verdrahtungsebenen (12, 13) der Mehrzahl von Verdrahtungsebenen (10-13) gitter- oder mäanderförmig ausgeformt sind und wobei die zweiten Leiterbahnen (31) in der oberen Verdrahtungsebene (13) der beiden übereinander liegenden Verdrahtungsebenen (12, 13) senkrecht zu den in der darunterliegenden Verdrahtungsebene (12) positionierten zweiten Leiterbahnen (32) ausgerichtet sind.

2. Integrierte Schaltungsanordnung nach Anspruch 1, **dadurch gekennzeichnet, dass** sich zumindest eine der zweiten Leiterbahnen (30) der integrierten Schaltungsanordnung über wenigstens 2 Verdrahtungsebenen (10-13) erstreckt.

3. Integrierte Schaltungsanordnung nach Anspruch 2, **dadurch gekennzeichnet, dass** direkt unter oder über einer der ersten Leiterbahnen (23) der integrierten Schaltung eine der zweiten Leiterbahnen (33) verläuft.

4. Integrierte Schaltungsanordnung nach einem der Ansprüche 1 bis 3, **dadurch gekennzeichnet, dass** die zweiten Leiterbahnen (30) aktiven Leitungen zugeordnet sind.

## Claims

1. Integrated circuit arrangement having a substrate (9), which has circuit elements, and a plurality of wiring planes (10-13) with the intended function of first conductor tracks (20) supporting the integrated circuit, wherein, in the wiring planes, second conductor tracks (30) are placed in regions (1) which are free of the first conductor tracks (20) to protect the integrated circuit arrangement, wherein an actuation circuit and an evaluation circuit for detecting an interruption, a short circuit of one of the second conductor tracks (31-33) with another conductor track or a rerouting of the second conductor tracks (31-33) are connected to the second conductor tracks (30), wherein second conductor tracks (31, 32) in two wiring planes (12, 13) lying one above the other of the plurality of wiring planes (10-13) are formed in a mesh-shaped or meandrous manner and wherein the second conductor tracks (31) in the upper wiring plane (13) of the two wiring planes (12, 13) lying one above the other are oriented perpendicular to the second conductor tracks (32) positioned in the wiring plane (12) lying beneath.

2. Integrated circuit arrangement according to Claim 1, **characterized in that** at least one of the second conductor tracks (30) of the integrated circuit arrangement extends over at least two wiring planes (10-13).

3. Integrated circuit arrangement according to Claim 2, **characterized in that** one of the second conductor tracks (33) runs directly below or above one of the first conductor tracks (23) of the integrated circuit.

4. Integrated circuit arrangement according to any of Claims 1 to 3, **characterized in that** the second conductor tracks (30) are assigned to active lines.

## Revendications

1. Système de circuit intégré comportant un substrat (9) qui comprend des éléments de circuit, et une pluralité de plans de câblage (10-13) présentant des premiers trajets de conduction (20) prenant en charge la fonction voulue du circuit intégré, dans lequel des seconds trajets de conduction (30) se trouvant dans les plans de câblage sont placés dans des zones (1) libérés par les premiers trajets de conduction (20) pour protéger le système de circuit intégré, dans lequel un circuit de commande et un circuit d'évaluation sont connectés aux seconds trajets de conduction (30) pour détecter une interruption, un court-circuit de l'un des seconds trajets de conduction (31-33) avec un autre trajet de conduction, ou une déviation des seconds trajets de conduction (31-33), dans lequel des seconds trajets de conduction (31, 32) se trouvant dans deux plans de câblage (12, 13) superposés l'un à l'autre de la pluralité de plans de câblage (10-13) sont réalisés sous la forme d'une grille ou de méandres et dans lequel les seconds trajets de conduction (31) se trouvant dans les plans de câblage supérieurs (13) des deux plans de câblage superposés l'un à l'autre (12, 13) sont orientés perpendiculairement aux seconds trajets de conduction (32) se trouvant dans les plans de câblage (12) inférieurs.

2. Système de circuit intégré selon la revendication 1, **caractérisé en ce qu'**au moins l'un des seconds trajets de conduction (30) du système de circuit intégré s'étend sur au moins 2 plans de câblage (10-13).

3. Système de circuit intégré selon la revendication 2, **caractérisé en ce que** l'un des seconds trajets de conduction (33) passe directement en dessous ou au-dessus de l'un des premiers trajets de conduction (23) du circuit intégré.

4. Système de circuit intégré selon l'une quelconque des revendications 1 à 3, **caractérisé en ce que** les seconds trajets de conduction (30) sont associés à des conducteurs actifs.
